(19) Europäisches Patentamt
European Patent Office
Office européen des brevets

(11) **EP 2 008 965 B1**

(12) **FASCICULE DE BREVET EUROPEEN**

(45) Date de publication et mention
de la délivrance du brevet:
**01.07.2020 Bulletin 2020/27**

(21) Numéro de dépôt: **08158743.8**

(22) Date de dépôt: **23.06.2008**

(51) Int Cl.:
*B81B 3/00* (2006.01)     *G01L 1/18* (2006.01)
*G01C 19/00* (2013.01)    *G01C 19/5769* (2012.01)
*G01C 19/5755* (2012.01)  *G01C 19/574* (2012.01)
*H03H 9/02* (2006.01)     *G01P 15/097* (2006.01)
*G01P 15/08* (2006.01)

(54) **Dispositif résonant à détection piézorésistive réalisé en technologies de surface**

Resonanzvorrichtung mit piezoelektrischer Erfassung für den Einsatz in Oberflächentechnologien

Resonant device with piezoresistive detection made using surface technologies

(84) Etats contractants désignés:
**DE FR GB**

(30) Priorité: **25.06.2007 FR 0755992**

(43) Date de publication de la demande:
**31.12.2008 Bulletin 2009/01**

(73) Titulaire: **Commissariat à l'Énergie Atomique
et aux Énergies Alternatives
75015 Paris (FR)**

(72) Inventeur: **Robert, Philippe
38000 GRENOBLE (FR)**

(74) Mandataire: **Ilgart, Jean-Christophe et al
BREVALEX
95, rue d'Amsterdam
75378 Paris Cedex 8 (FR)**

(56) Documents cités:
**EP-A- 1 273 896        EP-A- 1 626 282
US-A1- 2005 034 529     US-B1- 6 389 898**

# Description

## DOMAINE TECHNIQUE

L'invention concerne un dispositif résonant à détection piézorésistive réalisé en technologies de surface.

Le domaine de l'invention est notamment celui des micro/nano-capteurs silicium, des accéléromètres, des gyromètres, des capteurs de force.

## ÉTAT DE LA TECHNIQUE ANTÉRIEURE

Pour analyser l'état de la technique antérieure on va analyser successivement celui des capteurs résonants et celui des capteurs piézorésistifs.

Les capteurs résonants

Dans l'état de l'art, les capteurs résonants peuvent être réalisés :

- soit en technologie de volume, dans laquelle l'élément sensible du capteur est réalisé sur toute l'épaisseur du substrat, généralement en utilisant des gravures humides du silicium ou du quartz,
- soit en technologie de surface, dans laquelle le substrat silicium est usiné uniquement sur une fraction de son épaisseur, typiquement sur quelques micromètres à quelques dizaines de micromètres d'épaisseur.

Le domaine de l'invention est celui des capteurs MEMS (« Micro Electro-Mechanical System ») en technologie de surface, comme décrit, par exemple, dans le document référencé [1] en fin de description.

On constate que sur des capteurs inertiels de type résonants réalisés en technologie de surface :

- Les résonateurs vibrent dans le plan et les électrodes d'excitation / détection sont obtenues par gravure plasma DRIE (« Deep Reactive Ion Etching »).
- L'usinage par gravure DRIE et la libération par gravure d'une couche sacrificielle permet d'optimiser la structure (« design ») du capteur, avec notamment une possibilité de rapprochement du résonateur par rapport à la charnière.

Dans tous ces capteurs, la détection se fait par le biais :

- soit de moyens électrostatiques,
- soit de moyens piézorésistifs, à résistances implantées.

Dans le cas d'une miniaturisation des capteurs, notamment pour les capteurs NEMS (ou « Nano Electro-Mechanical System »), une détection devient problématique :

- du fait de très faibles valeurs de capacités à mesurer dans le cas d'une détection électrostatique, ou
- du fait de la difficulté de réalisation de jauges piézorésistives dans le cas d'une détection avec implantation de résistances.

Les capteurs piézorésistifs

Le domaine de l'invention est notamment celui des capteurs résonants à détection piézorésistive réalisés en technologie de surface, présentant une sensibilité et une précision élevées (rapport Signal/Bruit, faible dérive en température), adaptables aux capteurs NEMS, c'est-à-dire aux capteurs de très petites dimensions (échelle nanométrique).

Dans l'état de l'art des capteurs MEMS piézorésistifs non résonants, les jauges se trouvant en surface du corps d'épreuve ne détectent qu'une contrainte hors du plan. Il en découle :

- une restriction importante des structures (« designs ») de capteurs, notamment dans le cas de capteurs bi-axes intégrés, dans le cas de capteurs inertiels par exemple,
- une mauvaise adaptation à des capteurs réalisés en technologie de surface,
- une mauvaise adaptation à des capteurs « ultra-miniaturisés », tels les capteurs NEMS, tant il est difficile de définir, avec une précision suffisante et sans ajout de contraintes mécaniques dues aux métallisations sur le corps d'épreuve, les zones de dopage et de connectique pour la réalisation de ponts de jauges sur des poutres de quelques dizaines de nanomètres de largeur.

Le document référencé [2] décrit un autre type de capteur dans lequel des jauges piézorésistives sont réalisées par dépôt d'une couche conductrice sur le résonateur. Mais un tel dépôt peut conduire à plusieurs inconvénients majeurs :

- l'ajout de contraintes dans le résonateur,
- une baisse du facteur de qualité du résonateur,
- l'apparition d'étapes critiques en plus des étapes de la réalisation du résonateur proprement dit : dépôt d'une couche très mince de matériau conducteur avec un contrôle très strict de l'épaisseur, alignement et photolithographie et gravure des jauges sur la poutre critique,
- une détection se faisant hors plan, ce qui peut être un inconvénient en terme de structure, surtout si l'on souhaite avoir une excitation électrostatique isolée du substrat (« bulk »), dans le cas d'un résonateur en silicium monocristallin par exemple.

Le document référencé [3] décrit un autre type de capteur dans lequel les jauges sont définies par gravure du silicium. Le silicium n'est plus dopé en surface et la détection se fait dans le plan. Une telle configuration est bien adaptée à une technologie de surface et à la réalisation de capteurs de très petites dimensions (NEMS). Par contre, elle ne permet pas d'obtenir des sensibilités et des stabilités importantes. La réponse du capteur est, en effet, directement proportionnelle au signal des jauges piézorésistives. Or les coefficients piézorésistifs sont fortement dépendant de la température.

Le document EP 1 273 896 divulgue un capteur résonant.

L'invention a pour objet de pallier aux inconvénients des dispositifs de l'art connu en proposant un dispositif résonant (résonateur et/ou capteur) à détection piézorésistive, réalisé en technologie de surface, présentant une sensibilité et une précision élevées (bon rapport signal/bruit, faible dérive en température), plus simple et plus efficace pour de petites dimensions.

**EXPOSÉ DE L'INVENTION**

L'invention concerne un dispositif résonant à détection dans le plan piézorésistive réalisé en technologies de surfaces sur un substrat selon les termes de la revendication 1.

Le dispositif résonant est notamment pourvu d'une poutre vibrante formée d'un seul tenant avec le substrat, notamment par gravure, de sorte que ladite poutre soit reliée, de manière fixe, à ce substrat en une jonction, des moyens d'excitation de ce résonateur et des moyens de détection comprenant au moins une jauge de contrainte pourvue d'une poutre suspendue réalisée en matériau piézorésistif, en ce que chaque jauge de contrainte a au moins un plan commun avec la poutre vibrante, et est reliée à cette poutre vibrante en un point situé en dehors de la jonction et le positionnement de la jauge de contrainte étant choisi pour maximiser la contrainte exercée sur ladite jauge pour une déflection donnée de poutre vibrante, la poutre suspendue et la poutre vibrante étant chacune faite de silicium, la poutre suspendue présentant une épaisseur inférieure à la poutre vibrante.

Selon un mode préféré, le résonateur présentant une longueur L dans ledit plan, le point est situé à une distance inférieure ou égale à ¼ de L.

Dans un mode de réalisation avantageux du dispositif de l'invention, chaque jauge piézorésistive comprend au moins un nanofil silicium.

Dans un autre mode de réalisation avantageux du dispositif de l'invention, chaque jauge piézorésistive comprend au moins deux branches parallèles.

Avantageusement, les moyens d'excitation sont des moyens électrostatiques, thermiques ou piézoélectriques.

Avantageusement, les moyens de détection comprennent des moyens de mesure de la contrainte de la jauge par une mesure de résistance entre l'extrémité de la jauge de type poutre et l'encastrement du résonateur au support ou entre deux branches parallèles et rapprochées de la jauge.

Avantageusement chaque jauge de contrainte piézorésistive peut être disposée perpendiculairement au résonateur. Le résonateur et chaque jauge de contrainte piézorésistive peuvent être réalisés dans un même matériau piézorésistif, qui peut être du silicium, du SiGe..., le résonateur et chaque jauge de contrainte piézorésistive étant alors reliés mécaniquement et électriquement. Chaque jauge de contrainte piézorésistive peut être définie par gravure d'une poutre dans le silicium, cette jauge de contrainte piézorésistive travaillant en tension/compression.

L'invention concerne également un dispositif qui comprend un capteur résonant, par exemple silicium, qui comporte au moins un résonateur associé à un élément susceptible d'entraîner une variation de ses caractéristiques (contrainte) en fonction de la quantité à mesurer, et dans lequel une variation de la fréquence du résonateur, détectée par au moins une jauge de contrainte associée, résulte de cette variation de caractéristiques. Chaque résonateur, muni d'au moins un encastrement dans un substrat, comporte des moyens d'excitation, qui peuvent être des moyens électrostatiques, thermiques ou piézoélectriques, et des moyens de détection comprenant au moins une jauge de contrainte piézorésistive reliée au résonateur, et dans lequel chaque jauge de contrainte piézorésistive a un plan commun avec le résonateur, et est disposée au voisinage d'un encastrement du résonateur.

Avantageusement chaque résonateur peut vibrer dans le plan. Les moyens d'excitation de chaque résonateur peuvent comprendre au moins une électrode d'excitation de celui-ci. Chaque jauge de contrainte piézorésistive peut travailler en compression/tension. Chaque jauge de contrainte piézorésistive peut être définie par gravure de silicium.

Dans une telle fonction capteur, une variation de la fréquence de résonance du résonateur découle de la variation de ses caractéristiques, cette variation de fréquence étant détecté par les jauges de contraintes piézorésistives associées ; cette variation étant déduite de la mesure de la fréquence de résonance du résonateur, par les jauges de contraintes au cours du temps.

Ainsi, pour un capteur de type inertiel, une masse sismique, associée au résonateur, exerce sous l'action d'une accélération, une contrainte sur le résonateur. Cette contrainte induit une variation de fréquence sur le résonateur. De même, pour un capteur chimique, en présence de ces molécules spécifiques venant se « greffer » sur le résonateur qui est recouvert d'un matériau susceptible de capter certaines molécules, la masse effective du résonateur change, ce qui modifie sa fréquence de résonance.

Le dispositif de l'invention présente les avantages suivants :

- Il permet de réaliser un résonateur à détection piézorésistive, où la partie résonateur est découplée de la partie jauge piézorésistive. La partie résonateur et la partie jauge piézorésistive, qui sont reliées entre elles, peuvent être optimisés séparément. On peut ainsi :

  • optimiser la position de la jauge piézorésistive sur le résonateur pour accroître l'effet bras de levier,
  • réduire la section de la jauge piézorésistive pour augmenter sa sensibilité, sans modifier la fréquence de résonance du résonateur.

- Il permet de réaliser une mesure simple et sensible, particulièrement bien adaptée à une miniaturisation poussée.
- Il permet de réaliser une mesure différentielle de la fréquence de résonance, par montage en pont de Wheatstone des jauges piézorésistives.
- La sensibilité par une réduction de la section de la jauge piézorésistive, qui est amincie (dans l'épaisseur) est ainsi augmentée.
- Il permet d'utiliser une technologie très simple, par exemple gravure de la jauge piézorésistive lors de la gravure du résonateur et/ou du capteur : Il n'y a pas besoin de dépôt ou d'implantations supplémentaires.

Contrairement à une approche de capteur piézorésistif classique comme décrit par exemple dans le document [3], le dispositif de l'invention permet de décorréler la sensibilité du détecteur (donné au premier ordre par le résonateur) de la sensibilité des jauges piézorésistives (La dérive thermique des coefficients piézorésistifs n'influe pas sur la stabilité et/ou précision du capteur).

Par rapport aux résonateurs et capteurs résonants de l'état de l'art connu, principalement basés sur la détection capacitive du mouvement des résonateurs, la mesure d'un pont de jauge est beaucoup plus simple qu'une mesure capacitive généralement utilisée pour les capteurs résonants silicium, notamment lorsque l'on utilise des composants de très petites dimensions (NEMS), compte tenu des très faibles capacités en jeu.

Par rapport aux capteurs résonants à détection piézorésistive de l'état de l'art, comme décrit par exemple dans le document référencé [1], on bénéficie dans le dispositif de l'invention d'une absence de métallisation sur la poutre et de la possibilité d'une mise en résonance du résonateur dans le plan, ce qui permet notamment une excitation du résonateur par peignes capacitifs par exemple et d'une manière générale par des électrodes isolées électriquement du substrat.

Par rapport à l'état de l'art, comme décrit par exemple dans le document référencé [2], la jauge piézorésistive n'est plus définie par dépôt ou implantation mais par gravure. Cette jauge piézorésistive, qui correspond par exemple à une poutre silicium définie par gravure (sèche ou humide), est libérée du substrat par une seconde gravure (sèche ou humide). On élimine ainsi les problèmes liés aux dépôts de couches conductrices ou à l'implantation des jauges. Une telle approche est particulièrement bien adaptée à une technologie de surface et à une mise en résonance des résonateurs dans le plan (intérêt en termes de structure).

Le dispositif de l'invention peut être utilisé dans de nombreuses applications, et notamment pour :

- des bases de temps, des filtres mécaniques,
- des accéléromètres, des gyromètres pour des applications automobile, téléphonie mobile, avionique, ...
- des capteurs chimiques résonants.

## BRÈVE DESCRIPTION DES DESSINS

La figure 1 illustre un premier mode de réalisation de type de résonateur du dispositif de l'invention.
La figure 2 illustre un second mode de réalisation de type de résonateur du dispositif de l'invention.
Les figures 3A et 3B illustrent un premier mode de réalisation de type capteur du dispositif de l'invention.
Les figures 4A et 4B illustrent un second mode de réalisation de type capteur du dispositif de l'invention.
La figure 5 illustre un troisième mode de réalisation de type capteur du dispositif de l'invention.
Les figures 6A à 6C et 6A' à 6C' illustrent les étapes d'un premier exemple de réalisation, respectivement dans des vues en coupe et de dessus.
Les figures 7A à 7F et 7A' à 7F' (la figure 7E' n'existe pas) illustrent les étapes d'un second exemple de réalisation, respectivement dans des vues en coupe et de dessus.
Les figures 8A à 8G et 8A' à 8G' (la figure 8B' n'existe pas) illustrent les étapes de fabrication d'un mode de réalisation du dispositif de l'invention, respectivement dans des vues en coupe et de dessus.
La figure 9 illustre un autre mode de réalisation du dispositif de l'invention.

## EXPOSÉ DÉTAILLÉ DE MODES DE RÉALISATION PARTICULIERS

L'invention concerne un dispositif résonant (résonateur et/ou capteur) à détection piézorésistive réalisé en technologies de surfaces. Ce dispositif comprend un résonateur muni d'au moins un encastrement dans un substrat, comportant des moyens d'excitation, par exemple des moyens électrostatiques, thermiques ou piézoélectriques, et des moyens de détection réalisés par au moins une jauge de contrainte piézorésistive reliée au résonateur et ayant un plan commun avec celui-ci, un volume étant libéré sous cette jauge de contrainte et ce résonateur.

Pour un maximum d'efficacité, la jauge piézorésistive est placée au voisinage d'un encastrement du résonateur afin d'être située dans une zone de forte contrainte. En conséquence, la jauge aura peu d'influence sur la fréquence propre du résonateur. Elle peut ainsi être positionnée préférentiellement perpendiculairement au résonateur (de type poutre par exemple), et le plus proche possible de l'encastrement pour augmenter l'effet bras de levier, c'est-à-dire la contrainte vue par la jauge. Elle peut être obtenue par gravure dans du silicium, de manière à être en suspension au dessus du substrat, après gravure d'une couche sacrificielle.

## Modes de réalisation de type résonateur

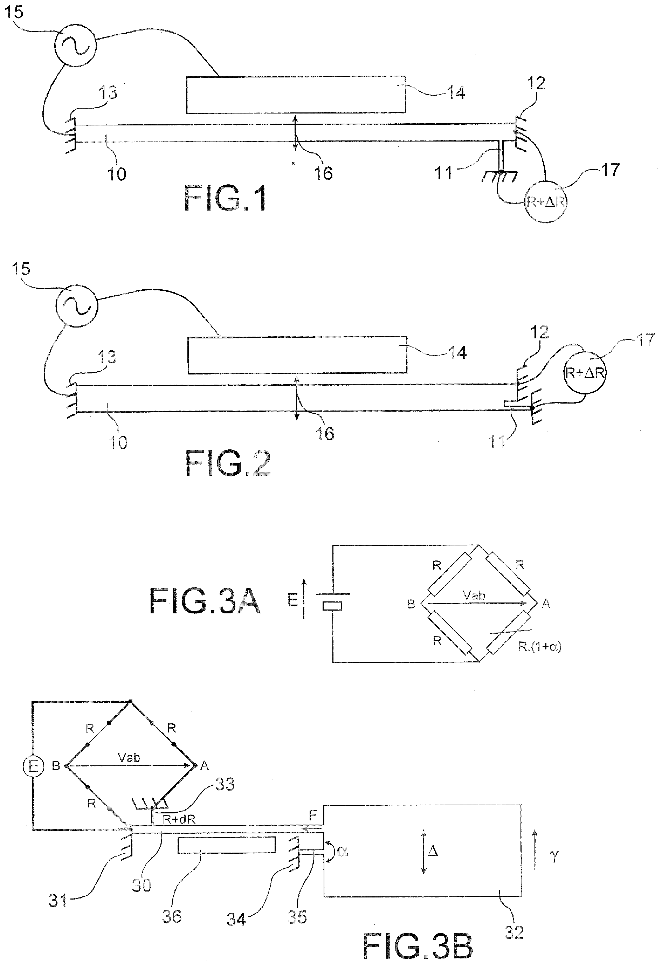

Dans un premier mode de réalisation de type résonateur, le dispositif de l'invention est un résonateur simple. Comme illustré sur la figure 1 une jauge de contrainte piézorésistive 11 de type poutre est solidaire du résonateur de type poutre 10 et placée perpendiculairement à celui-ci en un endroit proche d'un des deux encastrements 12 et 13. L'électrode fixe 14 d'excitation du résonateur 10 est portée à une tension alternative par rapport à celui-ci à l'aide d'un moyen de génération de tension alternative 15. Lorsque le résonateur est excité il vibre dans le plan, comme illustré par la double flèche 16.

Un homme de l'art est en mesure de positionner au mieux la jauge de contrainte de détection sur la poutre vibrante en procédant par exemple à une simulation éléments finis de la structure (via un logiciel classique de type ANSYS, Coventor, ...). Il cherche pour cela la position optimale tendant à maximiser la contrainte exercée sur la jauge de contrainte de détection pour une déflexion donnée de la poutre vibrante.

L'excitation de la résonance du résonateur 10 peut se faire par le biais de moyens électrostatiques, ou par le biais de moyens piézoélectriques, thermiques ou électromagnétiques, classiquement utilisés par l'homme de l'art.

La mesure de la contrainte de la jauge piézorésistive 11 peut se faire entre l'encastrement 12 du résonateur 10 et l'extrémité de la poutre de la jauge 11 à l'aide de moyens de mesure classiques 17.

Avantageusement la mesure de résistance peut se faire en utilisant un pont de Wheatstone.

Dans un second mode de réalisation le dispositif de l'invention est un résonateur simple, dans lequel la jauge de contrainte piézorésistive 11 est placée parallèlement au résonateur 10 en un point le plus éloigné possible de la ligne neutre, et proche de l'encastrement 12.

Pour un maximum d'efficacité, la jauge piézorésistive 11 a la section la plus faible possible, en respectant certaines conditions comme :

- une résistance comprise entre quelques ohms et quelques centaines d'ohms,
- une tenue au flambage/contrainte conforme aux spécifications du capteur, en ce qui concerne notamment la tenue au choc. En effet, pour un effort donné, la contrainte est proportionnelle à la section de la poutre définissant la jauge piézorésistive. Ainsi, on a une épaisseur différente entre le résonateur et/ou les autres parties du capteur et la (les) jauge(s) de contrainte.

## Modes de réalisation de type capteur

Le dispositif de l'invention est alors un capteur composé de deux corps d'épreuve « en cascade », qui sont respectivement le résonateur et la jauge de contrainte piézorésistive. Dans ce capteur, le résonateur est associé à un élément susceptible d'entraîner une variation de ses caractéristiques (contrainte, modification de la masse effective) en fonction de la quantité à mesurer. La quantité à mesurer (accélération, rotation, pression,...) exerce donc sur le résonateur une contrainte qui lui est proportionnelle. Cette contrainte a pour effet de modifier les conditions limites du résonateur, qui se traduit par une modification de sa fréquence de résonance ou de son amplitude de vibration. La mesure de vibration, par déformation du résonateur est ensuite mesurée par la jauge de contrainte piézoélectrique, qui est solidaire du résonateur, mais qui ne fait pas partie de celui-ci.

On va, à présent, considérer plusieurs modes de réalisation de type capteur.

## A - Accéléromètre résonant planaire à détection par jauges piézorésistives suivant l'invention

Un montage simple en pont de Wheatstone avec un seul élément sensible est illustré sur les figures 3A et 3B.

Comme illustré sur la figure 3A ce montage comprend un résonateur 30 fixé d'une part à un encastrement 31 et d'autre part à une masse sismique 32, et une électrode fixe d'excitation 36. Une jauge de contrainte piézorésistive 33 est placée perpendiculairement au résonateur, en un endroit proche de l'encastrement 31. La masse sismique 32 est également fixée à un encastrement 34 au moyen d'une charnière 35.

La mesure de résistance R+dR ou R(1+$\alpha$) de la jauge de contrainte 33 est réalisée en mesurant une différence de tension entre les points A et B, comme illustré sur les figures 3A et 3B, avec trois résistances R et un générateur E.

Les valeurs $\alpha$, F et $\Delta$ sont telles que :

$\alpha$ = rotation de la masse au niveau de la charnière 35, sous l'effet d'une accélération y,

F = contrainte exercée sur le résonateur 30 sous l'effet d'une accélération y, la mesure de dR permettant de déterminer l'accélération y,

$\Delta$ = axe sensible de la masse sismique 32.

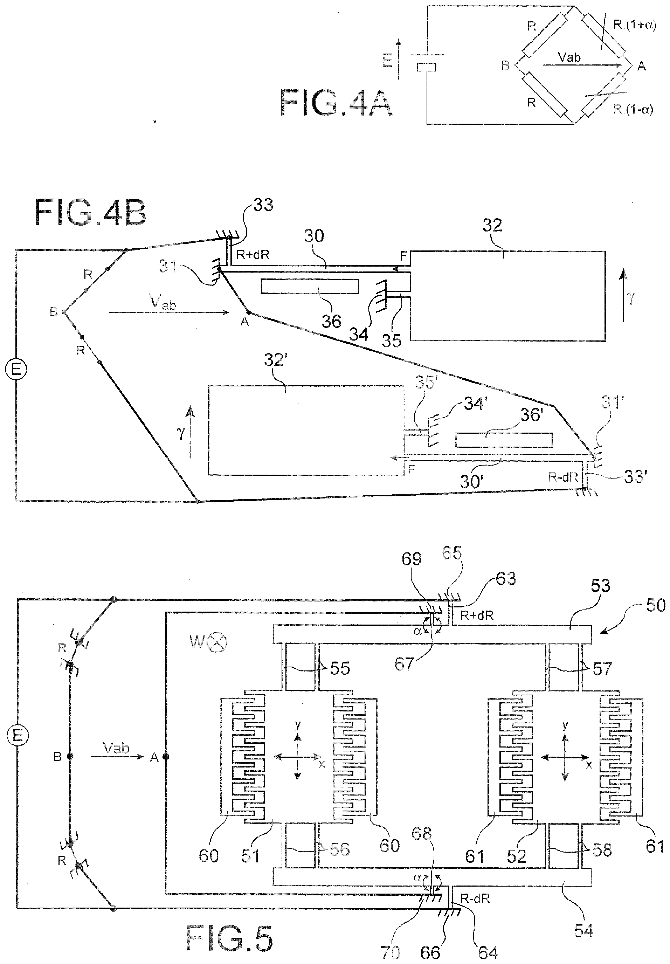

On peut également réaliser un montage différentiel en pont de Wheatstone comme illustré sur les figures 4A et 4B.

Dans ce montage on utilise deux montages identiques à celui illustré sur la figure 3A, les éléments du premier montage gardant les mêmes références 30 à 36 que sur la figure 3A, les éléments du second montage ayant des références 30' à 36'.

Dans ce montage différentiel les valeurs des jauges de contraintes 33 et 33' sont respectivement R+dR (ou R (1+$\alpha$)) et R-dR (ou R(1-$\alpha$)). On peut ainsi connaître la variation de résistance dR, liée à la variation de contrainte ($\sigma$) induite par la vibration du résonateur sur les jauges (dR étant proportionnel à la contrainte) et donc en déduire l'accélération $\gamma$. On sait, en effet, que dans le cas d'une jauge piézorésistive semi-conductrice, la résistivité change suivant la forme :

$$\frac{\Delta \rho}{\rho} = \frac{\pi_{44}}{2} \sigma_1 = \frac{\pi_{44} E}{2} \frac{\Delta l}{l} \, ,$$

avec $\pi_{44}$ le coefficient piézorésistif du matériau, et E le module de Young.

La contrainte longitudinale dans la jauge $\sigma_1$ est de la forme $\sigma_1$=F/ (w.h), avec h la largeur de la jauge et w sa hauteur.

Cette valeur de contrainte peut être facilement évaluée par une simulation éléments finis (logiciels ANSYS ou Coventor par exemple).

La variation de résistance est donc proportionnelle au déplacement du résonateur (c'est-à-dire sa vibration). On peut donc remonter à la fréquence de résonance du résonateur par le biais de la mesure de résistance des jauges piézorésistives.

Dans le cas d'un accéléromètre résonant planaire à détection par jauges piézorésistives suivant l'invention, tel qu'illustré sur la figure 3B, on peut avoir le dimensionnement typique suivant :

- épaisseur : quelques 0,1 $\mu$m voire quelques $\mu$m (par exemple : 4 $\mu$m)
- masse sismique : quelques 100 $\mu$m x quelques 100 $\mu$m (par exemple : 200 x 200 $\mu$m)
- charnière : quelques $\mu$m de long x quelques 0, 1 $\mu$m de large (par exemple : 5 $\mu$m de long x 0,8 $\mu$m de large)
- résonateur : quelques 100 $\mu$m de long x quelques 0,1 $\mu$m de large (par exemple : 400 $\mu$m de long x 1 $\mu$m de large)
- jauge piézorésistive : quelques 10 $\mu$m voire quelques 100 $\mu$m de long x quelques 0,1 $\mu$m de large (par exemple : 100 $\mu$m x 0,3 $\mu$m)
- espace entre l'encastrement du résonateur et la jauge : 0,5 $\mu$m à quelques $\mu$m (par exemple 1,5 $\mu$m),
- espace entre la charnière et le résonateur : 0,5 $\mu$m

à quelques $\mu$m (par exemple 2 $\mu$m).

B - Gyromètre résonant planaire à détection par jauges piézorésistives suivant l'invention

Le concept de base d'un gyromètre résonant, basé sur la détection de la force de Coriolis sur un système de type diapason, est donné dans le document référencé [4]. Dans le cas de l'invention, la force de Coriolis s'exerce directement sur les jauges piézorésistives. La mesure du pont de jauges piézorésistives, permet de connaître la vitesse de rotation $\Omega$.

La figure 5 illustre un gyromètre à montage différentiel en pont de Wheatstone. Comme schématisé sur cette figure, le gyromètre 50 se compose d'un support, non représenté, et de deux masses sismiques 51, 52 qui sont mobiles dans le plan (X, Y) du support, et qui peuvent vibrer. Deux bras de liaison 53, 54, mobiles par rapport au support et parallèles entre eux, sont reliés aux masses mobiles par l'intermédiaire de bras de flexion 55, 56, 57 et 58 ayant une flexibilité suffisante pour permettre les mouvements relatifs des deux masses 51, 52 par rapport aux bras de liaison, tout en étant suffisamment rigides pour transmettre les mouvements de ces deux masses aux bras de liaison. De préférence, les bras de liaison 53 et 54 et les bras de flexion, 55, 56, 57 et 58 forment un cadre rectangulaire.

Des moyens sont prévus pour mettre les masses 51 et 52 en vibration dans le plan (X, Y) du support, par exemple des peignes d'excitation 60, 61 s'imbriquant dans une ou les deux faces de chaque masse mobile 51, 52. Ces peignes 60, 61 engendrent par l'intermédiaire de forces électrostatiques un déplacement en va-et-vient de chaque masse dans une première direction X, ici de gauche à droite de la feuille. D'autres moyens peuvent être envisagés, comme une excitation électromagnétique.

Les masses 51, 52 sont excitées, de préférence à la résonance ou au voisinage de la résonance, par le biais de forces électrostatiques appliquées par l'intermédiaire des structures en peignes inter-digités 60, 61 : l'ensemble des masses 51, 52 et des moyens de liaisons 53, 54, 55, 56, 57 et 58 forme ainsi un résonateur d'excitation. Le fonctionnement à la résonance permet en effet d'obtenir une forte amplitude de déplacement, et un grand facteur de qualité, augmentant d'autant la sensibilité du gyromètre. Avantageusement, la vibration des masses est en opposition de phase, c'est-à-dire que leurs mouvements sont en direction opposées à chaque instant : la distance séparant les deux masses est variable, cette variation étant tolérée par les bras de flexion.

Lorsque le gyromètre 50 subit un déplacement angulaire autour d'un axe z perpendiculaire au support, une force de Coriolis est générée sur chaque masse, perpendiculairement aux axes X et Z et donc ici dans la direction verticale Y de la feuille, issue de la composition de la vibration forcée par les peignes 60, 61 avec la vitesse angulaire $\Omega$. Les forces de Coriolis sont transmises aux bras de liaison 53 et 54 par les bras de flexion 55, 56, 57 et 58.

Chaque bras de liaison 53 ou 54 est relié d'une part à une première extrémité d'une jauge de contrainte piézorésistive 63 ou 64 disposée perpendiculairement à celui-ci, dont l'autre extrémité est reliée à un encastrement 65 ou 66, et à une charnière 67 ou 68 dont l'autre extrémité est reliée à un encastrement 69 ou 70.

L'angle α correspond à la rotation des masses au niveau des charnières 67 et 68, sous l'effet de la rotation Ω (effet de la force de Coriolis).

La tension mesurée entre les points A et B du pont de Wheatstone permet de connaître la variation de résistance dR, et donc la vitesse angulaire Ω.

Dans le cas du gyromètre résonant planaire à détection par jauges piézorésistives suivant l'invention, tel qu'illustré sur la figure 5, on peut avoir des dimensions du même ordre, que dans le cas du dimensionnement typique de l'accéléromètre suivant l'invention considéré ci-dessus, en ce qui concerne les jauges piézorésistives, les charnières et l'espace entre les jauges piézorésistives et les charnières, c'est-à-dire :

- jauges piézorésistives : quelques 10 μm voire 100 μm de long x quelques 0,1 μm de large (par exemple 100 μm x 0,3 μm),
- charnières : quelques μm de long x quelques 0,1 μm de large (par exemple 5 μm de long x 0,8 μm de large),
- espace entre un encastrement du résonateur et une jauge : 0,5 μm à quelques μm (par exemple 1,5 μm),
- espace entre une charnière et un résonateur : 0,5 μm à quelques μm (par exemple 2 μm).

Exemple de réalisation d'un montage simple d'accéléromètre

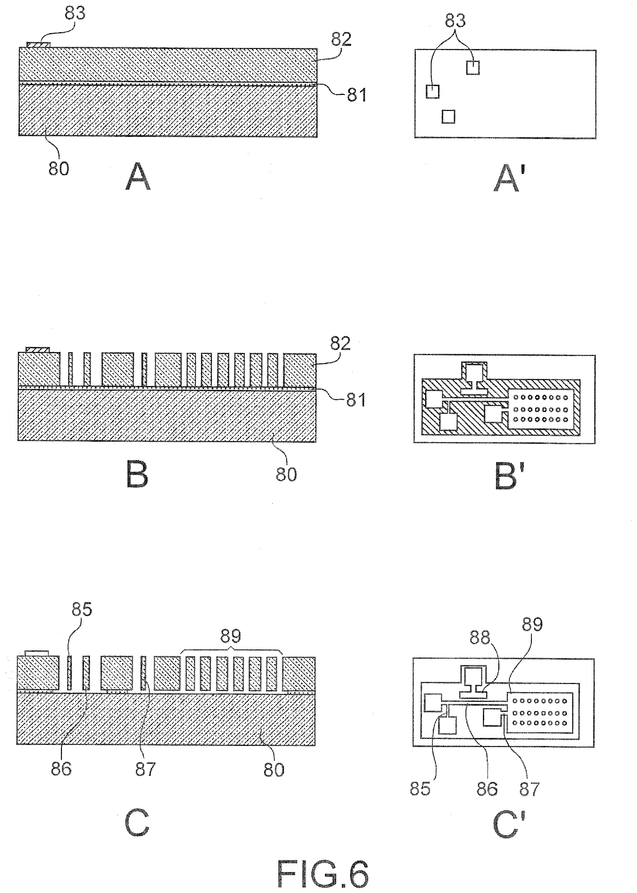

Dans un premier exemple de réalisation illustré sur les figures 6A à 6C (6A' à 6C') on a les étapes suivantes :

A. On dépose une couche de Ti/Ni/Au sur un substrat SOI comprenant un substrat de base (« bulk ») 80 en silicium, une couche sacrificielle en SiO$_2$ 81 (par exemple de 0,4 μm d'épaisseur) et une couche de silicium 82 (par exemple de 4 μm d'épaisseur). On délimite les contacts 83 par photolithographie et gravure.

B. On délimite la structure mécanique par photolithographie et gravure DRIE, avec arrêt sur la couche sacrificielle 81.

C. On libère les composants du dispositif de l'invention par exposition à l'acide fluorhydrique (humide ou vapeur) avec arrêt au bout d'une durée déterminée.

On obtient ainsi une jauge piézorésistive 85, un résonateur 86, une charnière 87, une électrode d'excitation du résonateur 88, et une masse sismique 89.

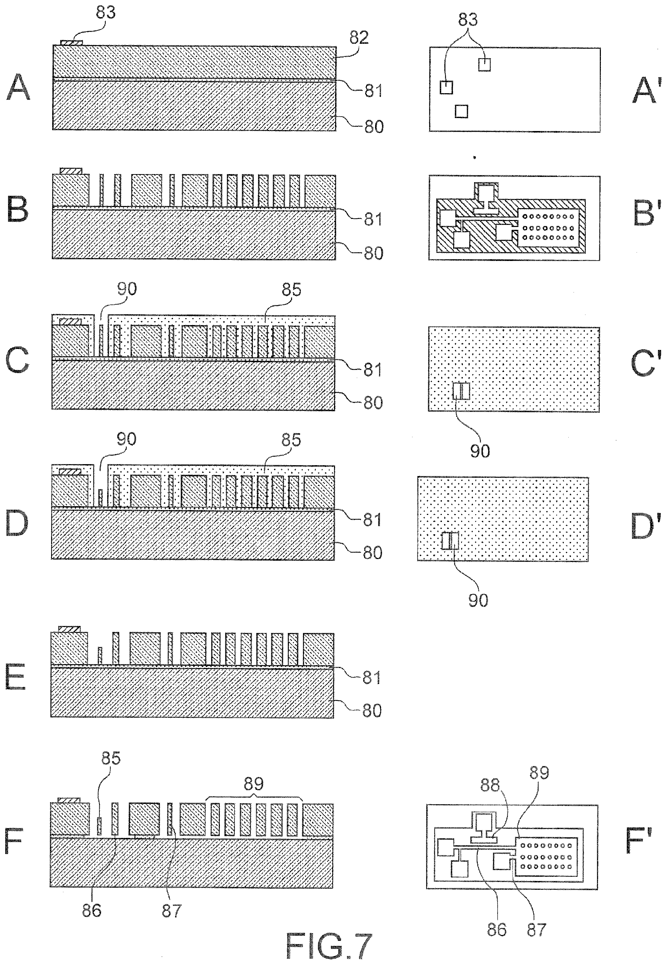

Dans un second exemple de réalisation, illustré sur les figures 7A à 7F (7A' à 7F', la figure 7E' n'existant pas), avec amincissement de la jauge de contrainte piézorésistive par gravure, on a les étapes suivantes :

A. On dépose une couche de Ti/Ni/Au sur un substrat de type SOI. On délimite les contacts par photolithographie et gravure.

B. On délimite la structure mécanique par photolithographie et gravure DRIE de la structure mécanique, avec arrêt sur la couche sacrificielle (SiO$_2$).

C. On dépose une couche de protection 84 de la structure mécanique par photolithographie, sauf dans la zone 90 de la jauge de contrainte.

D. On amincit la jauge de contrainte 90 par gravure DRIE avec arrêt au bout d'une durée déterminée.

E. On réalise un retrait (« stripping ») de la couche déposée à l'étape C.

F. On libère les composants du dispositif de l'invention par exposition à l'acide fluorhydrique (humide ou vapeur) avec arrêt au bout d'une durée déterminée.

Ces deux exemples de réalisation reposent sur l'utilisation de substrats SOI (composant en silicium monocristallin). Mais on peut généraliser de tels exemples à des composants en silicium polycristallin, en SiGe monocristallin, en SiGe polycristallin, ...

Autres modes de réalisation du dispositif de l'invention

Dans un mode de réalisation du dispositif de l'invention, les jauges piézorésistives suspendues peuvent être des nanofils silicium. Cela change légèrement la succession d'étapes présentée ci-dessus (les nanofils n'étant ni plus ni moins que des poutres de silicium de très faible section, typiquement de 100x100 nm$^2$, qu'il est possible de réaliser par lithographie ebeam par exemple). Le gros avantage est que ces nanofils ont la propriété d'avoir des coefficients piézorésistifs géants, comme décrit dans le document référencé [5], d'où potentiellement une sensibilité du capteur accrue.

Dans ce mode de réalisation, un exemple d'empilement adéquat est le suivant. Sur un substrat 95 de type SOI (par exemple 0,4 μm de SiO$_2$/0,15 μm Si) :

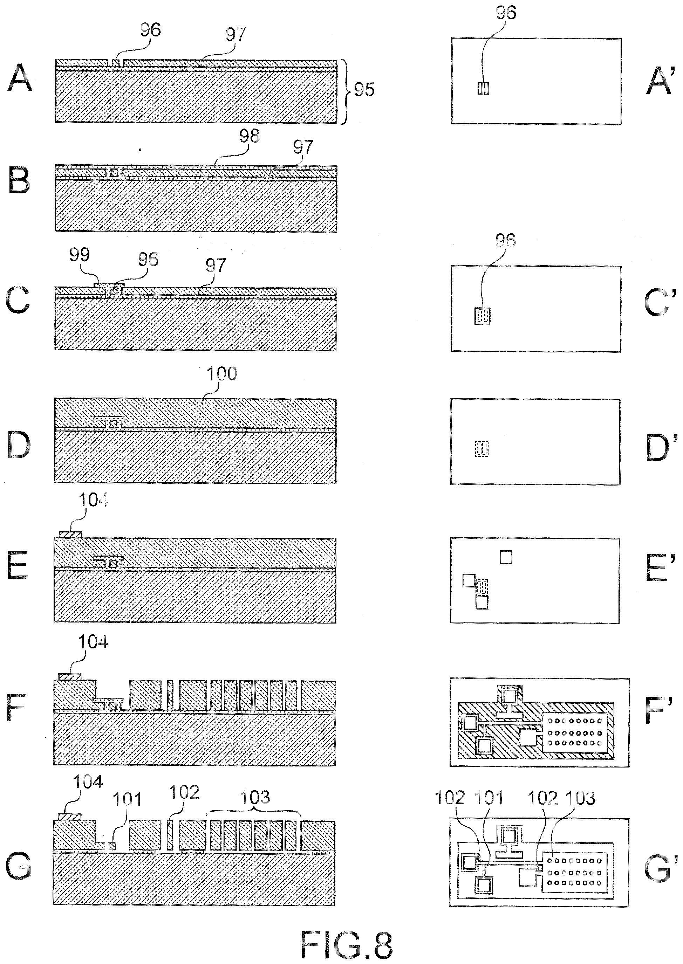

A. on délimite le (ou les) nanofil(s) par lithographie DUV ou ebeam, et on effectue une gravure Si d'une jauge nanofil 96 avec arrêt sur la couche de SiO$_2$ 97, comme illustré sur les figures 8A et 8A'.

B. On réalise le dépôt d'une couche de SiO$_2$ 98 (par exemple 0,5 μm) suivi d'une planarisation avec arrêt sur la couche de Si et dépôt de SiO$_2$ (0,5 μm par exemple), comme illustré sur la figure 8B.

C. On délimite une protection 99 de la jauge 96 par lithographie et gravure SiO$_2$, avec arrêt sur Si, comme illustré sur les figures 8C et 8C'.

D. On effectue une épitaxie Si 100 (4 μm) comme illustré sur les figures 8D et 8D'.

E. On effectue un dépôt de Ti/ Ni/Au (pour les contacts) et on délimite les contacts 104 par lithogravure, comme illustré sur les figures 8E et 8E'.

F. On délimite la structure mécanique par lithographie et gravure DRIE, avec arrêt sur la couche de SiO$_2$, comme illustré sur les figures 8F et 8F'.

G. On libère les composants par libération humide ou vapeur, avec arrêt au temps, comme illustré sur les figures 8G et 8G'. On obtient ainsi une jauge amincie (nanofil) 101, une charnière/résonateur 102 et une masse sismique 103.

Nous n'avons pas décrit ici les éléments illustrés déjà décrits au regard des figures 6A à 6C, 6A' à 6C', 7A à 7F et 7A' à 7F'.

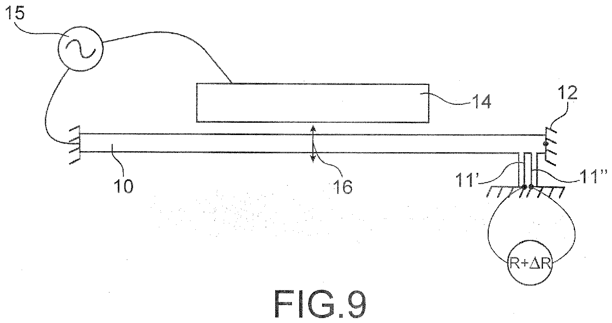

Dans un autre mode de réalisation du dispositif de l'invention illustré sur la figure 9, la jauge piézorésistive est constituée de deux branches parallèles 11' et 11'' rapprochées de manière à ce qu'elles voient pratiquement la même contrainte (typiquement avec 2 à 10 micromètres d'espacement). Dans ce cas, la mesure de résistance se fait entre les deux branches 11' et 11'' de la jauge.

## REFERENCES

[1] « Resonant accelerometer with self-test » de M. Aibele, K. Bauer, W. Fisher, F. Neubauer, U. Prechtel, J. Schalk, et H. Seidel (Sensors and actuators A92, 2001, pages 161 à 167).

[2] « High-mode resonant piezoresistive cantilever sensors for tens-fentogram resoluble mass sensing in air » de Dazhonh Jin et al (2006, J. Micromech., 16, pages 1017 à 1023).

[3] « Single-mask SOI fabrication process for linear and angular piezoresistive accelerometers with on-chip reference resistors » de Jasper Ekhund, E ; Shkel, A.M. ; (sensors, 2005 IEEE, 30 octobre-3 novembre 2005, pages 656 à 659).

[4] US 2006/032306

[5] "Piezoresistive effect in top-down fabricated silicon nanowires" de K. Reck, J. Richter, O. Hansen, et E.V. Thomsen (MEMS 2008, Tucson, AZ, USA, 13-17 janvier 2008).

## Revendications

1. Dispositif résonant à détection dans le plan piézorésistive réalisé en technologies de surfaces sur un substrat, le dispositif comprend un résonateur (10 ; 30), pourvu d'une poutre vibrante formée d'un seul tenant avec le substrat, notamment par gravure, de sorte que ladite poutre soit reliée, de manière fixe, à ce substrat en une jonction (12 ; 31), des moyens d'excitation (14 ; 36) de ce résonateur et des moyens de détection comprenant au moins une jauge de contrainte pourvue d'une poutre suspendue réalisée en matériau piézorésistif (11 ; 33), en ce que chaque jauge de contrainte a au moins un plan commun avec la poutre vibrante, et est reliée à cette poutre vibrante (10 ; 30) en un point situé en dehors de la jonction (12 ; 31) et le positionnement de la jauge de contrainte étant choisi pour maximiser la contrainte exercée sur ladite jauge pour une déflection donnée de poutre vibrante, le dispositif est caractérisé en que la poutre suspendue et la poutre vibrante sont chacune faites de silicium, et la poutre suspendue présente une épaisseur inférieure à la poutre vibrante.

2. Dispositif selon la revendication 1, dans lequel la poutre vibrante présente une longueur L dans ledit plan, ledit point est situé à une distance inférieure ou égale à ¼ de L.

3. Dispositif selon la revendication 1, dans lequel chaque jauge de contrainte est un nanofil silicium.

4. Dispositif selon la revendication 1, dans lequel chaque jauge de contrainte comprend deux branches parallèles (11', 11'').

5. Dispositif selon la revendication 1, dans lequel les moyens d'excitation sont des moyens électrostatiques, thermiques ou piézoélectriques.

6. Dispositif selon la revendication 1, dans lequel les moyens de détection comprennent des moyens de mesure de la contrainte de la jauge de contrainte par une mesure de résistance entre l'extrémité de la poutre vibrante et la jonction du résonateur au support ou entre deux branches parallèles (11', 11'') de la jauge.

7. Dispositif selon la revendication 1, dans lequel chaque jauge de contrainte est disposée perpendiculairement au résonateur.

8. Dispositif selon la revendication 1, dans lequel la poutre vibrante et chaque poutre suspendue sont reliés mécaniquement et électriquement.

9. Dispositif selon la revendication 8, dans lequel chaque poutre suspendue étant définie par une gravure dans le silicium, cette poutre suspendue travaillant en tension/compression.

10. Dispositif selon la revendication 1, qui comprend un capteur résonant qui comporte au moins un résonateur associé à un élément susceptible d'entraîner une variation de ses caractéristiques en fonction de la quantité à mesurer, et dans lequel une variation de la fréquence du résonateur, détectée par au moins une jauge de contrainte associée, résulte de cette variation de caractéristiques.

11. Dispositif selon la revendication 10, dans lequel chaque résonateur vibre dans le plan.

12. Dispositif selon la revendication 10, dans lequel les moyens d'excitation de chaque résonateur comprennent au moins une électrode d'excitation de celui-ci.

13. Dispositif selon la revendication 10, dans lequel chaque jauge de contrainte travaille en compression/tension.

14. Dispositif selon la revendication 10, dans lequel chaque jauge de contrainte est définie par gravure de silicium.

15. Dispositif selon la revendication 10, dans lequel le capteur comprend une masse sismique, associée au résonateur, et qui est apte sous l'action d'une accélération à exercer une contrainte sur ce résonateur.

16. Dispositif selon la revendication 10, dans lequel chaque résonateur est recouvert d'un matériau susceptible de capter certaines molécules.

17. Accéléromètre comprenant au moins un dispositif selon la revendication 15.

18. Gyromètre comprenant au moins un dispositif selon la revendication 15.

**Patentansprüche**

1. Resonanzvorrichtung mit piezoresistiver Detektion in der Ebene, wobei die Vorrichtung in Oberflächentechnologie auf einem Substrat hergestellt ist, und einen Resonator (10; 30) enthält, der mit einem schwingenden Balken versehen ist, der einstückig mit dem Substrat, insbesondere durch Ätzen, ausgebildet ist, so dass der Balken an einer Verbindung (12; 31) fest mit diesem Substrat verbunden ist, sowie Mittel (14; 36) zum Anregen dieses Resonators und Detektionsmittel, die zumindest einen Dehnungsmessstreifen enthalten, der mit einem aufgehängten Balken aus piezoresistivem Material (11; 33) versehen ist, wobei jeder Dehnungsmessstreifen zumindest eine mit dem schwingenden Balken gemeinsame Ebene aufweist und mit diesem schwingenden Balken (10; 30) an einem Punkt außerhalb der Verbindung (12; 31) verbunden ist, wobei die Positionierung des Dehnungsmessstreifens so gewählt ist, dass die auf den genannten Messstreifen ausgeübte Beanspruchung bei einer gegebenen Auslenkung des schwingenden Balkens maximiert wird,
wobei die Vorrichtung **dadurch gekennzeichnet ist, dass**
der aufgehängte Balken und der schwingende Balken jeweils aus Silizium hergestellt sind und der aufgehängte Balken eine geringere Dicke als der schwingende Balken aufweist.

2. Vorrichtung nach Anspruch 1,
wobei
der schwingende Balken in der genannten Ebene eine Länge L aufweist, wobei der genannte Punkt in einem Abstand kleiner oder gleich 1/4 von L liegt.

3. Vorrichtung nach Anspruch 1,
wobei
es bei dem Dehnungsmessstreifen jeweils um einen Nanodraht aus Silicium handelt.

4. Vorrichtung nach Anspruch 1,
wobei
der Dehnungsmessstreifen jeweils zwei parallele Schenkel (11', 11") enthält.

5. Vorrichtung nach Anspruch 1,
wobei
es sich bei den Anregungsmitteln um elektrostatische, thermische oder piezoelektrische Mittel handelt.

6. Vorrichtung nach Anspruch 1,
wobei
die Detektionsmittel Mittel zum Messen der Beanspruchung des Dehnungsmessstreifens durch Messen des Widerstands zwischen dem Ende des schwingenden Balkens und der Verbindung des Resonators mit dem Träger oder zwischen zwei parallelen Schenkeln (11', 11") des Messstreifens enthalten.

7. Vorrichtung nach Anspruch 1,
wobei
jeder Dehnungsmessstreifen senkrecht zum Resonator angeordnet ist.

8. Vorrichtung nach Anspruch 1,
wobei
der schwingende Balken und jeder aufgehängte Balken mechanisch und elektrisch verbunden sind.

9. Vorrichtung nach Anspruch 8,
wobei

jeder aufgehängte Balken durch eine Ätzung im Silicium definiert ist, wobei dieser aufgehängte Balken auf Zug/Druck arbeitet.

**10.** Vorrichtung nach Anspruch 1,
enthaltend einen Resonanzsensor, der zumindest einen Resonator enthält, der einem Element zugeordnet ist, das dazu geeignet ist, eine Veränderung seiner Eigenschaften in Abhängigkeit von der zu messenden Größe zu bewirken, und bei dem eine Veränderung der Frequenz des Resonators, die von zumindest einem zugeordneten Dehnungsmessstreifen erfasst wird, aus dieser Veränderung der Eigenschaften resultiert.

**11.** Vorrichtung nach Anspruch 10,
wobei
jeder Resonator in der Ebene schwingt.

**12.** Vorrichtung nach Anspruch 10,
wobei
die Mittel zum Anregen jedes Resonators zumindest eine Anregungselektrode zum Anregen desselben enthalten.

**13.** Vorrichtung nach Anspruch 10,
wobei
jeder Dehnungsmessstreifen auf Druck/Zug arbeitet.

**14.** Vorrichtung nach Anspruch 10,
wobei
jeder Dehnungsmessstreifen durch Ätzung von Silizium definiert ist.

**15.** Vorrichtung nach Anspruch 10,
wobei
der Sensor eine seismische Masse enthält, die dem Resonator zugeordnet ist und die unter der Wirkung einer Beschleunigung eine Beanspruchung auf diesen Resonator ausüben kann.

**16.** Vorrichtung nach Anspruch 10,
wobei
jeder Resonator mit einem Material bedeckt ist, das dazu geeignet ist, bestimmte Moleküle einzufangen.

**17.** Beschleunigungsmesser mit zumindest einer Vorrichtung nach Anspruch 15.

**18.** Gyrometer mit zumindest einer Vorrichtung nach Anspruch 15.

**Claims**

**1.** Resonant device for detection in the piezoresistive plane made using surface technologies on a substrate, the device comprises a resonator (10; 30), provided with a vibrating beam formed integrally with the substrate, in particular by etching, so that said beam is fixedly connected to this substrate at a junction (12; 31), excitation means (14; 36) of this resonator and detection means comprising at least one strain gauge provided with a suspended beam made of piezoresistive material (11; 33), in that each strain gauge has at least one plane in common with the vibrating beam, and is connected to this vibrating beam (10; 30) at a point situated outside the junction (12; 31) and the positioning of the strain gauge being chosen to maximize the stress exerted on said gauge for a given deflection of vibrating beam, the device is **characterized in that** the suspended beam and the vibrating beam are each made of silicon, and the suspended beam has a thickness less than the vibrating beam.

**2.** Device according to claim 1, **characterised in that** the vibrating beam has a length L in said plane, wherein said point is located at a distance less than or equal to ¼ of L.

**3.** Device according to claim 1, **characterised in that** each piezo-resistive gauge is a silicon nanowire.

**4.** Device according to claim 1, **characterised in that** each piezo-resistive gauge comprises two parallel arms (11, 11").

**5.** Device according to claim 1, **characterised in that** the excitation means are electrostatic, thermal or piezo-electric means.

**6.** Device according to claim 1, **characterised in that** the detection means comprise means of measuring the stress of the gauge by measuring the resistance between the end of the beam type gauge and the embedded portion of the resonator at the support or between two parallel arms (11', 11") of the gauge.

**7.** Device according to claim 1, **characterised in that** each piezo-resistive strain gauge is positioned perpendicularly to the resonator.

**8.** Device according to claim 1, **characterised in that** the vibrating beam and each suspended beam are connected mechanically and electrically.

**9.** Device according to claim 8, **characterised in that** each suspended beam is defined by etching a beam in the silicon, wherein this suspended beam operates in tension/compression.

**10.** Device according to claim 1, which comprises a resonant sensor that has at least one resonator associated to an element capable of creating a variation of its characteristics depending on the quantity to be measured, and in which a variation of the frequency of the resonator, detected by at least one associated strain gauge, results from this variation of characteristics.

11. Device according to claim 10, **characterised in that** each resonator vibrates in the plane.

12. Device according to claim 10, **characterised in that** the excitation means of each resonator comprise at least one electrode to excite it.

13. Device according to claim 10, **characterised in that** each piezo-resistive strain gauge operates in compression/tension.

14. Device according to claim 10, **characterised in that** each piezo-resistive strain gauge is defined by silicon etching.

15. Device according to claim 10, **characterised in that** a seismic mass, associated to the resonator, and that is capable, under the action of an acceleration, of exerting a stress on this resonator.

16. Device according to claim 10, **characterised in that** each resonator is coated with a material capable of capturing certain molecules.

17. Accelerometer comprising at least one device according to claim 15.

18. Gyrometer comprising at least one device according to claim 15.

FIG.1

FIG.2

FIG.3A

FIG.3B

## FIG.4A

## FIG.4B

## FIG.5

FIG.6

FIG.7

FIG.8

FIG.9

# EP 2 008 965 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1273896 A

- US 2006032306 A

**Littérature non-brevet citée dans la description**

- **DE M. AIBELE ; K. BAUER ; W. FISHER ; F. NEUBAUER ; U. PRECHTEL ; J. SCHALK ; H. SEIDEL.** Resonant accelerometer with self-test. *Sensors and actuators A92,* 2001, 161-167
- **DE DAZHONH JIN et al.** High-mode resonant piezoresistive cantilever sensors for tens-fentogram resoluble mass sensing in air. *J. Micromech.,* 2006, vol. 16, 1017-1023

- Single-mask SOI fabrication process for linear and angular piezoresistive accelerometers with on-chip reference resistors. **DE JASPER EKHUND, E ; SHKEL, A.M.** sensors. IEEE, 2005, 656-659
- **DE K. RECK ; J. RICHTER ; O. HANSEN ; E.V. THOMSEN.** Piezoresistive effect in top-down fabricated silicon nanowires. *MEMS,* 2008